# EUROPEAN PATENT APPLICATION

(11) **EP 4 228 008 A1**
(43) Date of publication of application: **16.08.2023**
(21) Application number: 20959218.7
(22) Date of filing: 30.10.2020
(51) Int. Cl.: H01L 29/786

(54) **METHOD FOR FORMING SIDEWALL IN FORK-SHAPED STRUCTURE AND SEMICONDUCTOR DEVICE WITH FORK-SHAPED STRUCTURE**

(71) Applicant: Huawei Technologies Co., Ltd., Shenzhen, Guangdong 518129 (CN)
(72) Inventor: WAN, Guangxing, Shenzhen, Guangdong 518129 (CN); WONG, Waisum, Shenzhen, Guangdong 518129 (CN)
(74) Representative: Gill Jennings & Every LLP
(86) International application number: PCT/CN2020/125335
(87) International publication number: WO 2022/088056

(57) **Abstract**

A method for forming a sidewall in a forksheet structure is disclosed. The method includes: providing a substrate (201); forming, on the substrate (201), an overlapping layer (202) in which first materials (2021) and second materials (2022) are sequentially stacked; forming a first mask layer (203) on the overlapping layer (202); forming a first trench (205) in the first mask layer (203); forming a second trench in the first trench (205) by forming a second mask layer (206) in the first mask layer (203) and the first trench (205); etching, through anisotropic etching, the second mask layer (206) along a direction perpendicular to the substrate (201), until the second mask layer (206) that is located between sides of the second trench and on a lower surface of the first trench (205) is removed, to form a third trench (207) based on the second trench; etching downwards from a lower surface of the third trench (207) by using the second mask layer (206) as a protective layer, to form a fourth trench that penetrates the overlapping layer (202) and extends to the substrate (201); and forming a sidewall (208) in the fourth trench. The method reduces requirements for photolithography precision and a photolithography capability during forming the sidewall (208).

## Description

### TECHNICAL FIELD

This application relates to the field of semiconductor technologies, and in particular, to a method for forming a sidewall in a forksheet structure and a forksheet semiconductor device.

### BACKGROUND

With continuous evolution of an integrated circuit technology, new processes and new structures are proposed. In 2019, the IMEC proposed a forksheet (forksheet) structure. The forksheet structure can effectively reduce a distance between an N-type metal-oxide semiconductor (N-type metal-oxide semiconductor, NMOS) and a P-type metal-oxide semiconductor (P-type metal-oxide semiconductor, PMOS), to reduce an area of a standard cell. Therefore, the forksheet structure is considered as a potential direction for a next-generation advanced process.

The existing forksheet structure includes a sidewall, and an NMOS and a PMOS located on both sides of the sidewall. Because a width of the sidewall is small, a distance between the NMOS and the PMOS is reduced. Currently, a principle of forming a sidewall is as follows: first forming an overlapping layer; forming a trench at the overlapping layer through photolithography; and forming the sidewall by filling the trench.

Because the sidewall is formed by filling the trench, and a width of the trench depends on photolithography, a width of the sidewall also depends on photolithography. In addition, because the width of the sidewall is small, the manner of forming the sidewall requires high photolithography precision and a high photolithography capability.

### SUMMARY

This application provides a method for forming a sidewall in a forksheet structure and a forksheet semiconductor device, to reduce high requirements for photolithography precision and a photolithography capability in a manner of forming a sidewall.

According to a first aspect, this application provides a method for forming a sidewall in a forksheet structure. The method includes: providing a substrate; forming, on the substrate, an overlapping layer in which first materials and second materials are sequentially stacked; forming a first mask layer on the overlapping layer; forming a first trench in the first mask layer; forming a second trench in the first trench by forming a second mask layer in the first mask layer and the first trench; etching, through anisotropic etching, the second mask layer along a direction perpendicular to the substrate, until the second mask layer that is located between sides of the second trench and on a lower surface of the first trench is removed, to form a third trench based on the second trench; etching downwards from a lower surface of the third trench by using the second mask layer as a protective layer, to form a fourth trench that penetrates the overlapping layer and extends to the substrate; and forming a sidewall in the fourth trench.

Because the sidewall is formed in the fourth trench, a width of the sidewall is determined by a width of the fourth trench. A principle of forming the fourth trench is as follows: forming the first trench in the first mask layer; forming the second trench in the first trench by forming the second mask layer in the first trench; removing, through anisotropic etching along the direction perpendicular to the substrate, the second mask layer that is located between the sides of the second trench and on the lower surface of the first trench, to obtain the third trench; and etching downwards from the lower surface of the third trench by using the second mask layer as a protective layer, to form the fourth trench that penetrates the overlapping layer and extends to the substrate. In other words, during forming the fourth trench, the photolithography process is only used during forming the first trench. Because the fourth trench is formed in the first trench, a width of the first trench is greater than the width of the fourth trench, that is, the width of the first trench is large. Therefore, during forming the first trench, this reduces requirements for photolithography precision and a photolithography capability. Further, during forming the sidewall, this reduces requirements for photolithography precision and a photolithography capability.

In a possible implementation, the method further includes: forming a first overlapping structure and a second overlapping structure on two sides of the sidewall, where the first overlapping structure, the second overlapping structure, and the sidewall are covered with a first dielectric layer and a second dielectric layer, one end of the first dielectric layer is on a same planewith one end of the first overlapping structure and one end of the second overlapping structure, one end of the second dielectric layer is on a same planewith the other end of the first overlapping structure and the other end of the second overlapping structure, and the other end of the first dielectric layer is at a preset distance from the other end of the second dielectric layer; removing a first target material covered by the first dielectric layer and the second dielectric layer in the first overlapping structure, and removing a second target material covered by the first dielectric layer and the second dielectric layer in the second overlapping structure; forming a third dielectric layer in a region from which the first target material is removed, to obtain a third overlapping structure; forming a fourth dielectric layer in a region from which the second target material is removed, to obtain a fourth overlapping structure; forming a first doped structure at two ends of the third overlapping structure, and forming a second doped structure at two ends of the fourth overlapping structure; removing the first target material in the third overlapping structure, to form a plurality of first channel layers; and removing the second target material in the fourth overlapping structure, to form a plurality of second channel layers. The first target material is a material that is in the first material and the second material and that is not used to form the first channel layer, the second target material is a material that is in the first material and the second material and that is not used to form the second channel layer, and a doping type of the first doped structure is opposite to a doping type of the second doped structure.

In a possible implementation, the method further includes: forming a first gate insulation layer on the first channel layer, and forming a second gate insulation layer on the second channel layer; and forming a first gate conductive layer on the first gate insulation layer, and forming a second gate conductive layer on the second gate insulation layer.

In a possible implementation, materials of the first gate insulation layer and the second gate insulation layer are the same, and materials of the first gate conductive layer and the second gate conductive layer are the same; or materials of the first gate conductive layer and the second gate conductive layer are the same.

In a possible implementation, the method further includes: removing the sidewall between the first dielectric layer and the second dielectric layer; forming a gate insulation layer on the first channel layer and the second channel layer; and forming a gate conductive layer on the gate insulation layer.

In a possible implementation, the forming a first overlapping structure and a second overlapping structure on two sides of the sidewall includes: forming a fifth overlapping structure and a sixth overlapping structure that are located on two sides of the sidewall by removing a to-be-removed mask layer and an overlapping layer that is located under the to-be-removed mask layer, where the to-be-removed mask layer is the first mask layer located outside sides of the first trench; forming a dummy gate structure covering the fifth overlapping structure, the sixth overlapping structure, and the sidewall, where a length of the dummy gate structure is equal to the preset distance; forming the first dielectric layer and the second dielectric layer at two ends of the dummy gate structure; removing a region that is not covered by the dummy gate structure, the first dielectric layer, and the second dielectric layer in the fifth overlapping structure, to obtain the first overlapping structure; and removing a region that is not covered by the dummy gate structure, the first dielectric layer, and the second dielectric layer in the sixth overlapping structure, to obtain the second overlapping structure.

In a possible implementation, before forming the plurality of first channel layers and the plurality of second channel layers, the method further includes: removing the dummy gate structure.

In a possible implementation, the method further includes: forming a fifth dielectric layer on the substrate, where the plurality of first channel layers, the plurality of second channel layers, the first doped structure, and the second doped structure are located on the fifth dielectric layer.

In a possible implementation, materials of the first channel layer and the second channel layer are different.

In a possible implementation, the first doped structure is P-type doping, the second doped structure is N-type doping, the material of the first channel layer is silicon-germanium, and the material of the second channel layer is silicon.

According to a second aspect, this application provides a forksheet semiconductor device, including a substrate; a sidewall disposed perpendicularly to the substrate; a plurality of first channel layers sequentially spaced apart on one side of the sidewall along a direction perpendicular to the substrate, where the first channel layer extends along the side of the sidewall; a plurality of second channel layers sequentially spaced apart on another side of the sidewall along a direction perpendicular to the substrate, where the second channel layer extends along the side of the sidewall; a first doped structure disposed at two ends of the plurality of first channel layers, and a second doped structure disposed at two ends of the plurality of second channel layers, where a doping type of the first doped structure is opposite to a doping type of the second doped structure; a first dielectric layer covering one end of a first surface of the plurality of first channel layers and one end of a first surface of the plurality of second channel layers, and a second dielectric layer covering the other end of the first surface of the plurality of first channel layers and the other end of the first surface of the plurality of second channel layers, where the first surface of the plurality of first channel layers is a surface, of the plurality of first channel layers, that is away from the sidewall, and the first surface of the plurality of second channel layers is a surface, of the plurality of second channel layers, that is away from the sidewall; a third dielectric layer disposed at two ends of a second surface of the plurality of first channel layers, and a fourth dielectric layer disposed at two ends of a second surface of the plurality of second channel layers, where the second surface of the plurality of first channel layers is a surface, of the plurality of first channel layers, that is adjacent to the first surface of the plurality of first channel layers and that is parallel with the substrate, and the second surface of the plurality of second channel layers is a surface, of the plurality of second channel layers, that is adjacent to the first surface of the plurality of second channel layers and that is parallel with the substrate; and a first gate insulation layer and a first gate conductive layer that are sequentially disposed on the first channel layer, and a second gate insulation layer and a second gate conductive layer that are sequentially disposed on the second channel layer.

In a possible implementation, the semiconductor device further includes a fifth dielectric layer on the substrate, where the plurality of first channel layers, the plurality of second channel layers, the first doped structure, and the second doped structure are located on the fifth dielectric layer.

In a possible implementation, materials of the first gate insulation layer and the second gate insulation layer are the same, and materials of the first gate conductive layer and the second gate conductive layer are the same; or materials of the first gate conductive layer and the second gate conductive layer are the same.

In a possible implementation, the sidewall between the first dielectric layer and the second dielectric layer is removed. The first gate insulation layer and the first gate conductive layer are sequentially disposed on a surface that is in contact with the removed sidewall and that is in the first channel layer. The second gate insulation layer and the second gate conductive layer are sequentially disposed on a surface that is in contact with the removed sidewall and that is in the second channel layer. Materials of the first gate insulation layer and the second gate insulation layer are the same, and materials of the first gate conductive layer and the second gate conductive layer are the same.

In a possible implementation, materials of the first channel layer and the second channel layer are different.

In a possible implementation, the first doped structure is P-type doping, the second doped structure is N-type doping, the material of the first channel layer is silicon-germanium, and the material of the second channel layer is silicon.

### BRIEF DESCRIPTION OF DRAWINGS

FIG. 1 is a schematic flowchart of forming a sidewall according to an embodiment of this application;
FIG. 2 is a schematic diagram of a structure obtained after a substrate, an overlapping layer, and a first mask layer are formed according to an embodiment of this application;
FIG. 3 is a schematic diagram of a structure obtained after a first trench is formed according to an embodiment of this application;
FIG. 4 is a schematic diagram of a structure obtained after a third trench is formed according to an embodiment of this application;
FIG. 5 is a schematic diagram of a structure obtained after a sidewall is formed according to an embodiment of this application;
FIG. 6 is a schematic flowchart of a first process according to an embodiment of this application;
FIG. 7 is a schematic diagram of a structure obtained after a fifth overlapping structure and a sixth overlapping structure are formed according to an embodiment of this application;
FIG. 8 is a schematic diagram of a structure obtained after a gap is formed according to an embodiment of this application;
FIG. 9 is a schematic diagram of a structure obtained after a dummy gate structure is formed according to an embodiment of this application;
FIG. 10 is a schematic diagram of a structure obtained after a first overlapping structure and a second overlapping structure are formed according to an embodiment of this application;
FIG. 11 is a schematic diagram of a structure obtained after a first doped structure and a second doped structure are formed according to an embodiment of this application;
FIG. 12 is a cross-sectional view of a structure along a direction a-a' shown in FIG. 11;
FIG. 13 is a schematic diagram of a structure obtained after a first channel layer and a second channel layer are formed according to an embodiment of this application;
FIG. 14 is a schematic diagram of a structure obtained after a first gate insulation layer, a second gate insulation layer, a first gate conductive layer, and a second gate conductive layer are formed according to an embodiment of this application;
FIG. 15 is a schematic diagram of a structure obtained after an electrode structure and an isolation layer are formed according to an embodiment of this application;
FIG. 16 is a diagram of an energy band of a first field effect transistor and a second field effect transistor;
FIG. 17 is a schematic diagram of a structure obtained after a sidewall between a first dielectric layer and a second dielectric layer is removed according to an embodiment of this application;
FIG. 18 is a schematic diagram of a structure obtained after a gate insulation layer and a gate conductive layer are formed according to an embodiment of this application; and
FIG. 19 is a schematic diagram of a structure obtained after a fifth dielectric layer, an electrode structure, and an isolation layer are formed according to an embodiment of this application.

### DESCRIPTION OF EMBODIMENTS

The following describes technical solutions of this application with reference to the accompanying drawings.

To make objectives, technical solutions, and advantages of this application clearer, the following clearly and completely describes technical solutions in this application with reference to the accompanying drawings in this application. It is clear that the described embodiments are some but not all of embodiments of this application. All other embodiments obtained by a person of ordinary skill in the art based on embodiments of this application without creative efforts shall fall within the protection scope of this application.

In the specification, embodiments, claims, and accompanying drawings of this application, terms such as "first" and "second" are merely used for differentiation and description, but should not be understood as an indication or implication of relative importance or an indication or implication of a sequence. In addition, terms "include", "have", or any other variant thereof are intended to cover a non-exclusive inclusion, for example, including a series of steps or units. Methods, systems, products, or devices are not necessarily limited to those steps or units that are literally listed, but may include other steps or units that are not literally listed or that are inherent to such processes, methods, products, or devices.

It should be understood that, in this application, "at least one" means one or more, and "a plurality of" means two or more. The term "and/or" is used to describe an association relationship between associated objects, and indicates that three relationships may exist. For example, "A and/or B" may represent the following three cases: Only A exists, only B exists, and both A and B exist, where A and B may be singular or plural. The character "/" usually indicates an "or" relationship between the associated objects. "At least one of the following items (pieces)" or a similar expression thereof refers to any combination of these items, including any combination of singular items (pieces) or plural items (pieces). For example, at least one (piece) of a, b, or c may represent: a, b, c, a and b, a and c, b and c, or a, b, and c, where a, b, and c may be singular or plural.

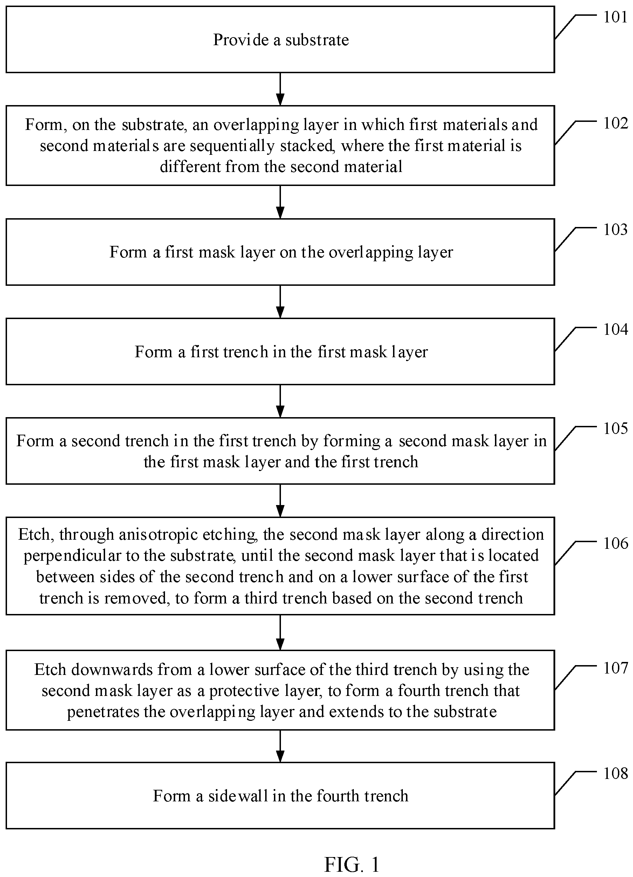

To resolve the foregoing technical problem, this application provides a method for forming a sidewall in a forksheet structure. FIG. 1 is a schematic flowchart of forming a sidewall according to an embodiment of this application. As shown in FIG. 1, the method includes the following steps.

101: Provide a substrate.

102: Form, on the substrate, an overlapping layer in which first materials and second materials are sequentially stacked, where the first material is different from the second material.

103: Form a first mask layer on the overlapping layer.

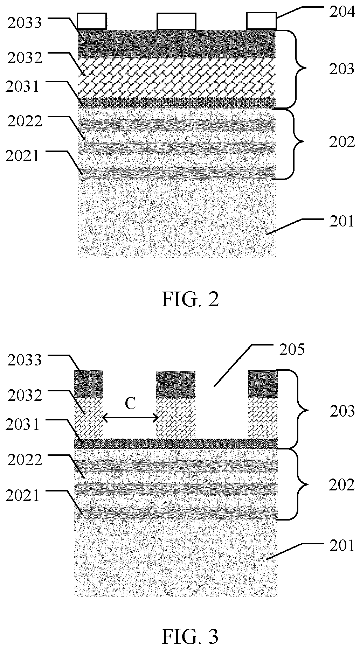

Refer to FIG. 2. In a possible implementation, a material of the substrate 201 is silicon, the first material 2021 is silicon germanium, the second material 2022 is silicon, and the overlapping layer 202 is formed by sequentially overlapping silicon germanium and silicon. The first mask layer 203 includes an oxide (oxide) layer 2031, a polycrystalline silicon (a-Si) layer 2032, and a silicon nitride (SiN) layer 2033 that are sequentially stacked. It should be noted that in FIG. 2, a layer of developed photoresist 204 is covered on the silicon nitride (SiN) layer 2033. A manufacturing process of the developed photoresist 204 is described in the following. Details are not described herein.

In another possible implementation, a material of the substrate 201 may alternatively be a semiconductor material such as germanium, and the first material 2021 and the second material 2022 may alternatively be, for example, germanium, a semiconductor compound (namely, a IV compound and a III-V compound), or another semiconductor material. A quantity of layers included in the overlapping layer 202 may also be determined based on a design requirement. The first mask layer 203 may further include more or fewer layers. This is not specially limited herein. A material of the first mask layer 203 may alternatively be another material that can be used as a mask layer and that is used in a semiconductor manufacturing process. This is not particularly limited herein.

104: Form a first trench in the first mask layer.

Refer to FIG. 3. In a possible implementation, the first trench 205 vertically penetrates the polycrystalline silicon (a-Si) layer 2032 and the silicon nitride (SiN) layer 2033 in the first mask layer 203. In other words, the first trench 205 does not completely penetrate the first mask layer 203. A process of forming the first trench 203 may be: coating the first mask layer 203 with photoresist, and performing exposure development on the photoresist, to remove the photoresist, on the first mask layer 203, that is used to form the first trench 205, so as to obtain the developed photoresist 204 shown in FIG. 2, where a region from which the photoresist is removed is used to form the first trench 205 shown in FIG. 2; and then etching downwards, through anisotropic etching by using the developed photoresist 204 as a protective layer, the first mask layer 203 in a region that is not covered by the photoresist 204, to form the first trench 205. An etching depth is a sum of thicknesses of the polycrystalline silicon (a-Si) layer 2032 and the silicon nitride (SiN) layer 2033 in the first mask layer 203. It should be noted that the process of forming the first trench 205 is merely an example, and is not intended to limit this application.

Alternatively, in another possible implementation, the first trench 205 may vertically and completely penetrate the first mask layer 203. Alternatively, the first trench 205 may vertically and partially penetrate the polycrystalline silicon (a-Si) layer 2032, the silicon nitride (SiN) layer 2033, and the oxide (oxide) layer 2031.

It should be noted that, after the first trench 205 is formed, the photoresist 204 on the first mask layer 203 is removed. In this embodiment of this application, a width of the first trench 205 is C, and is determined based on a width of the sidewall and widths of a first channel layer and a second channel layer that are formed on two sides of the sidewall. The sidewall, the first channel layer, and the second channel layer are described in the following.

105: Form a second trench in the first trench by forming a second mask layer in the first mask layer and the first trench.

A material of the second mask layer may be, for example, oxide or silicon nitride. This is not specifically limited. The material of the second mask layer may be the same as or different from a material of the first mask layer. This is not specially limited herein. It should be noted that, when the first mask layer includes a plurality of materials, the material of the second mask layer may be the same as one of the plurality of materials included in the first mask layer, or may be different from the plurality of materials included in the first mask layer.

A process of forming the second mask layer may be: forming, through deposition, the second mask layer on a surface of a structure obtained after the first trench is formed, that is, forming the second mask layer in the first mask layer and the first trench (namely, sides and a lower surface of the first trench). Because there is a height difference between the lower surface of the first trench and an upper surface of the first mask layer, the second trench may be formed in the first trench by forming the second mask layer.

106: Etch, through anisotropic etching, the second mask layer along a direction perpendicular to the substrate, until the second mask layer that is located between sides of the second trench and on the lower surface of the first trench is removed, to form a third trench based on the second trench.

During etching, a portion of the second mask layer on the first mask layer is also consumed.

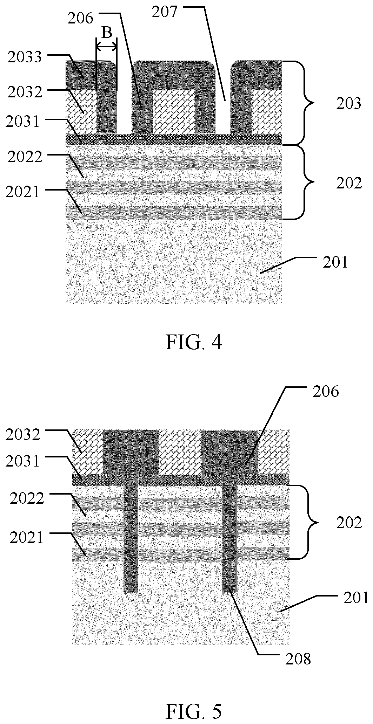

Refer to FIG. 4. In a possible implementation, the third trench 207 uses the second mask layer 206 as sides of the third trench 207, and a lower surface of the third trench 207 is on a same plane with the lower surface of the first trench 205. In other words, the lower surface of the third trench 207 is horizontally parallel with an upper surface of the oxide (oxide) layer 2031 in the first mask layer 203. In FIG. 4, the material of the second mask layer 206 is silicon nitride.

107: Etch downwards from the lower surface of the third trench by using the second mask layer as a protective layer, to form a fourth trench that penetrates the overlapping layer and extends to the substrate.

In the process, the second mask layer is used as the protective layer to etch downwards from the lower surface of the third trench through anisotropic etching, to form the fourth trench that penetrates the overlapping layer and extends to the substrate. It should be noted that the fourth trench may not completely penetrate the substrate, or may completely penetrate the substrate. This is not specially limited herein.

108: Form the sidewall in the fourth trench.

Specifically, the fourth trench is filled, to form the sidewall. A material of the sidewall may be, for example, an insulation material such as oxide or SiN. The material of the sidewall may be the same as or different from the material of the second mask layer.

As shown in FIG. 5, in a possible implementation, the material of the sidewall 208 is the same as the material of the second mask layer 206, that is, the material of the sidewall 208 is silicon nitride. It should be noted that in FIG. 5, after the sidewall is formed, silicon nitride on the polycrystalline silicon layer 2032 is removed.

It is clear that a width of the fourth trench is controlled by controlling a thickness (namely, a thickness (B in FIG. 4) of the second mask layer on sides of the first trench) of the second mask layer, to control the width of the sidewall. During forming the sidewall, this implements self-alignment, reduces dependence on a photolithography process, and reduces requirements for photolithography precision and a photolithography capability. In the manner, this may further reduce a size of the sidewall, and further reduce a size of a semiconductor device.

It can be learned from the foregoing that, because the sidewall is formed in the fourth trench, the width of the sidewall is determined by the width of the fourth trench. A principle of forming the fourth trench is as follows: forming the first trench in the first mask layer; forming the second trench in the first trench by forming the second mask layer in the first trench; removing, through anisotropic etching along the direction perpendicular to the substrate, the second mask layer that is located between the sides of the second trench and on the lower surface of the first trench, to obtain the third trench; and etching downwards from the lower surface of the third trench by using the second mask layer as a protective layer, to form the fourth trench that penetrates the overlapping layer and extends to the substrate. In other words, during forming the fourth trench, the photolithography process is only used during forming the first trench. Because the fourth trench is formed in the first trench, a width of the first trench is greater than the width of the fourth trench, that is, the width of the first trench is large. Therefore, during forming the first trench, this reduces requirements for photolithography precision and a photolithography capability. Further, during forming the sidewall, this reduces requirements for photolithography precision and a photolithography capability.

After the sidewall is formed, a forksheet semiconductor device can be formed by using any one of a plurality of processes. The following two processes are used as examples to describe a process of forming the forksheet semiconductor device.

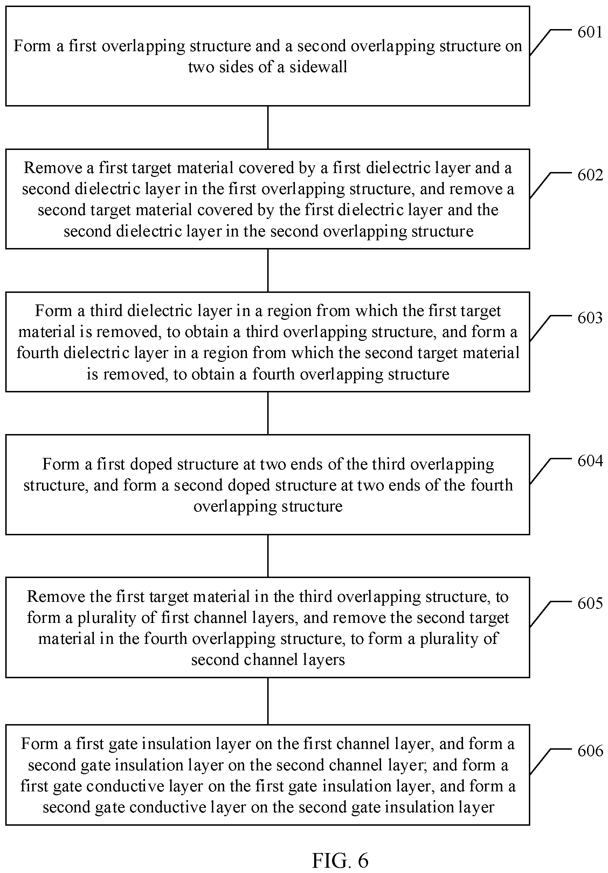

As shown in FIG. 6, a procedure of the first process is as follows:

601: Form a first overlapping structure and a second overlapping structure on two sides of the sidewall, where the first overlapping structure, the second overlapping structure, and the sidewall are covered with a first dielectric layer and a second dielectric layer, one end of the first dielectric layer is on a same plane with one end of the first overlapping structure and one end of the second overlapping structure, one end of the second dielectric layer is on a same plane with the other end of the first overlapping structure and the other end of the second overlapping structure, and the other end of the first dielectric layer is at a preset distance from the other end of the second dielectric layer. A length of the first overlapping structure and a length of the second overlapping structure are less than a length of the sidewall.

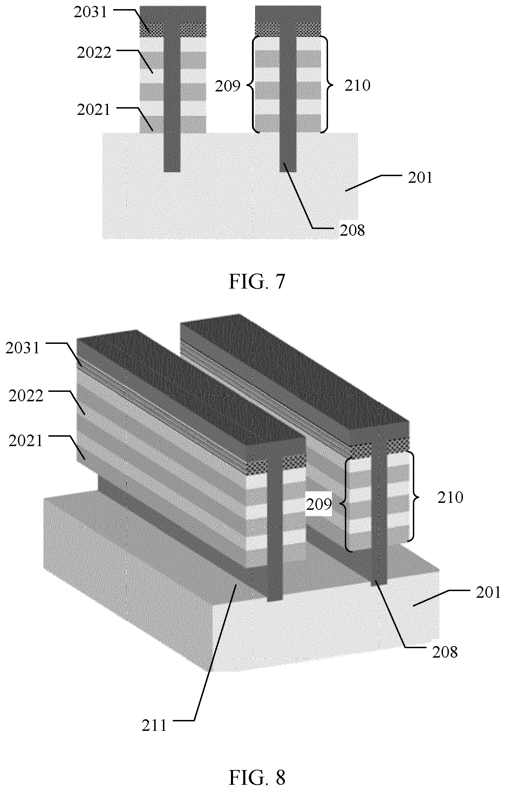

In a possible implementation, a process of forming the first overlapping structure and the second overlapping structure on two sides of the sidewall may include:
first forming a fifth overlapping structure and a sixth overlapping structure that are located on two sides of the sidewall by removing a to-be-removed mask layer and an overlapping layer that is located under the to-be-removed mask layer, where the to-be-removed mask layer is the first mask layer located outside sides of the first trench. Refer to FIG. 5. In a possible implementation, the to-be-removed mask layer is the polycrystalline silicon layer 2032 and the oxide (oxide) layer 2031 that are in the first mask layer 203 and that are located outside the sides of the first trench. Based on FIG. 5, FIG. 7 shows the fifth overlapping structure and the sixth overlapping structure that are obtained after the to-be-removed mask layer and the overlapping layer under the to-be-removed mask layer are removed. The fifth overlapping structure 209 and the sixth overlapping structure 210 are located on two sides of the sidewall 208. It should be noted that, in a process of forming the fifth overlapping structure 209 and the sixth overlapping structure 210, heights of the second mask layer 206 and the sidewall 208 also have a specific loss.

Refer to FIG. 8. In another possible implementation, to avoid forming a parasitic device caused by connecting the substrate to a field effect transistor formed based on the fifth overlapping structure and the sixth overlapping structure, and avoid affecting performance of the field effect transistor, after the fifth overlapping structure and the sixth overlapping structure are formed, a gap 211 is formed between the substrate 201, the fifth overlapping structure 209, and the sixth overlapping structure 210 by etching the substrate 201, and a fifth dielectric layer is formed in the gap 211 through deposition. Therefore, the substrate 201 may be separated from the fifth overlapping structure 209 and the sixth overlapping structure 210 by using the fifth dielectric layer, so that the substrate 201 is separated, by using the fifth dielectric layer, from the field effect transistor formed based on the fifth overlapping structure 209 and the sixth overlapping structure 210. This further avoids forming a parasitic device caused by connecting the substrate 201 to the field effect transistor formed based on the fifth overlapping structure 209 and the sixth overlapping structure 210, and improves performance of the field effect transistor.

A material of the fifth dielectric layer may be an insulation material, for example, oxide or silicon nitride. This is not specifically limited in this application.

It should be noted that the field effect transistor formed based on the fifth overlapping structure includes a plurality of first channel layers, a first doped structure, and the like, and the field effect transistor formed based on the sixth overlapping structure includes a plurality of second channel layers, a second doped structure, and the like. It can be learned from the foregoing that, because the fifth overlapping structure and the sixth overlapping structure are located on the fifth dielectric layer, the plurality of first channel layers, the first doped structure, the plurality of second channel layers, and the second doped structure are all located on the fifth dielectric layer.

It should be noted that the manner of forming the fifth dielectric layer is merely an example, and is not intended to limit this application.

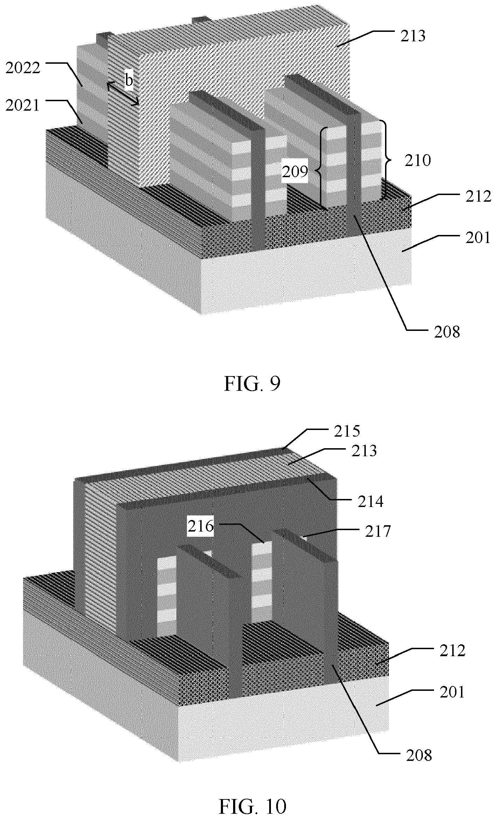

Then, a dummy gate structure covering the fifth overlapping structure, the sixth overlapping structure, and the sidewall is formed, where a length of the dummy gate structure is equal to the preset distance. The length of the dummy gate structure is determined based on a design requirement of the device. This is not specially limited herein. Refer to FIG. 9. In a possible implementation, the dummy gate structure 213 covers the fifth overlapping structure 209, the sixth overlapping structure 210, and the sidewall 208, and the fifth overlapping structure 209 and the sixth overlapping structure 210 are located on the fifth dielectric layer 212. The length of the dummy gate structure 213 is b.

Finally, the first dielectric layer and the second dielectric layer are formed at two ends of the dummy gate structure, a region that is not covered by the dummy gate structure, the first dielectric layer, and the second dielectric layer in the fifth overlapping structure is removed, to obtain the first overlapping structure, and a region that is not covered by the dummy gate structure, the first dielectric layer, and the second dielectric layer in the sixth overlapping structure is removed, to obtain the second overlapping structure.

Materials of the first dielectric layer and the second dielectric layer may be insulation materials, for example, oxide or silicon nitride. Refer to FIG. 10. In a possible implementation, the first overlapping structure 216 and the second overlapping structure 217 are located on two sides of the sidewall 208. In addition, the first overlapping structure 216, the second overlapping structure 217, and the sidewall 208 are covered by the dummy gate structure 213, the first dielectric layer 214, and the second dielectric layer 215. The first dielectric layer 214 and the second dielectric layer 215 are located at two ends of the dummy gate structure 213.

602: Remove a first target material covered by the first dielectric layer and the second dielectric layer in the first overlapping structure, and remove a second target material covered by the first dielectric layer and the second dielectric layer in the second overlapping structure.

The first target material is a material that is in the first material and the second material and that is not used to form the first channel layer, and the second target material is a material that is in the first material and the second material and that is not used to form the second channel layer. The first target material may be the same as or different from the second target material. This is not specially limited in this application.

In a possible implementation, the first material is silicon germanium, the second material is silicon, the first target material is silicon, and the second target material is silicon germanium.

603: Form a third dielectric layer in a region from which the first target material is removed, to obtain a third overlapping structure, and form a fourth dielectric layer in a region from which the second target material is removed, to obtain a fourth overlapping structure.

Materials of the third dielectric layer and the fourth dielectric layer may be insulation materials, for example, oxide or silicon nitride. The material of the third dielectric layer may be the same as or different from the material of the fourth dielectric layer.

It should be noted that the first overlapping structure from which the first target material is removed and on which the third dielectric layer is formed is referred to as the third overlapping structure, and the second overlapping structure from which the second target material is removed and on which the fourth dielectric layer is formed is referred to as the fourth overlapping structure.

604: Form the first doped structure at two ends of the third overlapping structure, and form the second doped structure at two ends of the fourth overlapping structure. A doping type of the first doped structure is opposite to a doping type of the second doped structure. In other words, if the doping type of the first doped structure is an N-type, the doping type of the second doped structure is a P-type. If the doping type of the first doped structure is a P-type, the doping type of the second doped structure is an N-type.

In 604, the first doped structure may be formed at two ends of the third overlapping structure through deposition, and the second doped structure may be formed at two ends of the fourth overlapping structure through deposition. It should be noted that, when the first doped structure and the second doped structure are formed, deposition may be performed before doping. In other words, doping is not performed during deposition, or a doped structure of a corresponding doping type may be deposited. Materials of the first doped structure and the second doped structure before doping may be semiconductor materials, for example, silicon, germanium, and silicon germanium.

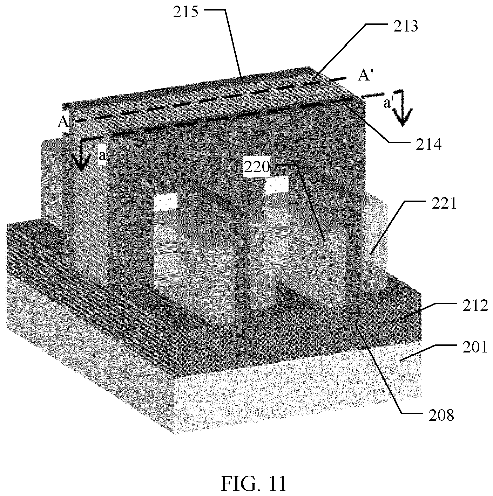

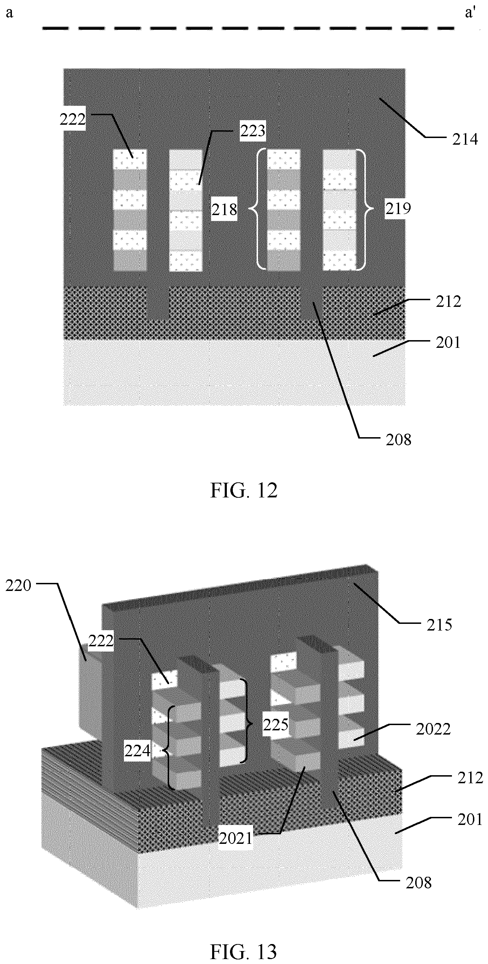

Refer to FIG. 11. In a possible implementation, there are two first doped structures 220 separately located at two ends of the third overlapping structure, and there are two second doped structures 221 separately located at two ends of the fourth overlapping structure. It should be noted that FIG. 11 is a three-dimensional diagram. To clearly represent structures blocked by the first doped structure 220 and the second doped structure 221 in the figure, the first doped structure 220 and the second doped structure 221 are represented in a translucent manner. FIG. 12 is a cross-sectional view of a structure along a direction a-a' shown in FIG. 11. In FIG. 12, the first material 2021 is silicon germanium, the second material 2022 is silicon, and the third overlapping structure 218 and the fourth overlapping structure 219 are located on two sides of the sidewall 208. The first target material is the second material, that is, the first target material is silicon. The second target material is the first material, that is, the second target material is silicon germanium. The third dielectric layer 222 is located in the region from which the first target material is removed, and the fourth dielectric layer 223 is located in the region from which the second target material is removed.

A source drain region of the first field effect transistor is obtained by forming the first doped structure, and a source drain region of the second field effect transistor is obtained by forming the second doped structure. The first field effect transistor is a field effect transistor formed based on the first overlapping structure (namely, the fifth overlapping structure), and the second field effect transistor is a field effect transistor formed based on the second overlapping structure (namely, the sixth overlapping structure).

605: Remove the first target material in the third overlapping structure, to form the plurality of first channel layers, and remove the second target material in the fourth overlapping structure, to form the plurality of second channel layers. The first target material and the second target material are described above, and details are not described herein again.

The first channel layer is a channel region of the first field effect transistor, and the second channel layer is a channel region of the second field effect transistor.

A material of the first channel layer may be the same as or different from a material of the second channel layer. This is not specially limited herein. It should be noted that if the material of the first channel layer is different from the material of the second channel layer, appropriate materials may be separately selected for the first channel layer and the second channel layer based on a type of the field effect transistor corresponding to the first channel layer and a type of the field effect transistor corresponding to the second channel layer, to improve performance of the field effect transistor.

The first channel layer and the second channel layer may or may not be doped. This is not specially limited herein. It should be noted that if the first channel layer and the second channel layer are doped, a doping type of the first channel layer is opposite to the doping type of the first doped structure, and a doping type of the second channel layer is opposite to the doping type of the second doped structure.

It should be noted that in a possible implementation, if the dummy gate structure covers the third overlapping structure and the fourth overlapping structure, the dummy gate structure needs to be removed. Then, the first target material in the third overlapping structure is removed, to form the plurality of first channel layers, and the second target material in the fourth overlapping structure is removed, to form the plurality of second channel layers.

Refer to FIG. 13. In a possible implementation, the first material 2021 is silicon germanium, the second material 2022 is silicon, the first target material is silicon, and the second target material is silicon germanium. The material of the first channel layer 224 is silicon germanium, the material of the second channel layer 225 is silicon, the doping type of the first doped structure 220 is a P-type, the doping type of the second doped structure is an N-type, and the first channel layer 224 and the second channel layer 225 are not doped. It can be learned from the foregoing that because the doping type of the first doped structure 220 is a P-type, and the doping type of the second doped structure is an N-type, a channel type of the field effect transistor formed based on the first overlapping structure is a P-type, and a channel type of the field effect transistor formed based on the second overlapping structure is an N-type. In addition, because the channel layer made of silicon germanium helps improve performance of the P-type field effect transistor, and the channel layer made of silicon helps improve performance of the N-type field effect transistor, silicon is selected as the material of the second channel layer 225, and silicon germanium is selected as the material of the first channel layer 224, to improve performance of the field effect transistor formed based on the first overlapping structure and the field effect transistor formed based on the second overlapping structure.

It should be noted that FIG. 13 is a schematic diagram of a structure obtained after the first channel layer and the second channel layer are formed based on the cross-sectional view along a direction of A-A' shown in FIG. 11. Because FIG. 13 is a three-dimensional diagram, the second doped structure is blocked by another structure.

606: Form a first gate insulation layer on the first channel layer, and form a second gate insulation layer on the second channel layer; and form a first gate conductive layer on the first gate insulation layer, and form a second gate conductive layer on the second gate insulation layer.

Materials of the first gate insulation layer and the second gate insulation layer may be, for example, silicon dioxide or a high-k material (for example, ZrO₂, HfO₂, or Al₂O₃). This is not specially limited herein. Materials of the first gate conductive layer and the second gate conductive layer may be, for example, a metal material or heavily doped polycrystalline silicon. This is not specifically limited herein.

Materials of the first gate insulation layer and the second gate insulation layer may be the same or may be different, and materials of the first gate conductive layer and the second gate conductive layer may be the same or may be different. If the materials of the first gate insulation layer and the second gate insulation layer are the same, and/or the materials of the first gate conductive layer and the second gate conductive layer are the same, the manufacturing process can be simplified, and manufacturing costs can be reduced.

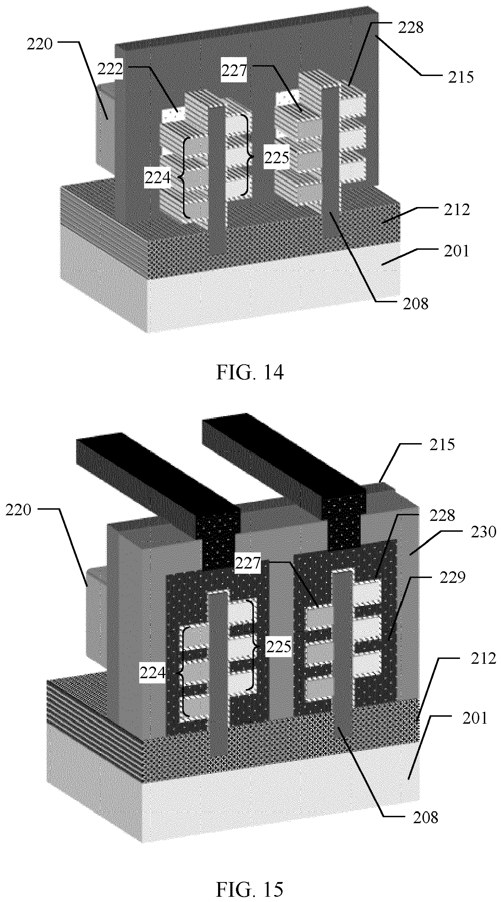

Refer to FIG. 14. In a possible implementation, the first gate insulation layer is formed on an exposed surface of the first channel layer 224, and the second gate insulation layer is formed on an exposed surface of the second channel layer 225. The exposed surface of the first channel layer 224 is a surface that is not in contact with another structure in the first channel layer 224, and the exposed surface of the second channel layer 225 is a surface that is not in contact with another structure in the second channel layer 225. The first gate conductive layer is deposited on a surface, on the first gate insulation layer, away from the first channel layer, and the second gate conductive layer is deposited on a surface, on the second gate insulation layer, away from the second channel layer. It should be noted that in FIG. 14, the first gate insulation layer and the first gate conductive layer are not separately shown. In other words, in FIG. 14, 227 indicates a combination of the first gate insulation layer and the first gate conductive layer. Similarly, the second gate insulation layer and the second gate conductive layer are not separately shown. In other words, in FIG. 14, 228 indicates a combination of the second gate insulation layer and the second gate conductive layer. In addition, as shown in FIG. 14, after the first gate insulation layer and the first gate conductive layer are formed, a first gate insulation layer and a first gate conductive layer are also formed on the sidewall. To simplify the manufacturing process, the first gate insulation layer and the first gate conductive layer on the sidewall may not need to be removed. Similarly, a second gate insulation layer and a second gate conductive layer on the sidewall may not need to be removed. Details are not described herein again.

It can be learned from the foregoing that the semiconductor device manufactured by using the process includes two field effect transistors: the first field effect transistor and the second field effect transistor. The first field effect transistor includes the plurality of first channel layers, the first doped structure, the first gate insulation layer, and the first gate conductive layer. The plurality of first channel layers are a channel region of the first field effect transistor, the first gate insulation layer and the first gate conductive layer form a gate of the first field effect transistor, and the first doped structure forms the source drain region of the first field effect transistor. The second field effect transistor includes the plurality of second channel layers, the second doped structure, the second gate insulation layer, and the second gate conductive layer. The plurality of second channel layers are a channel region of the second field effect transistor, the second gate insulation layer and the second gate conductive layer form a gate of the second field effect transistor, and the second doped structure forms the source drain region of the second field effect transistor.

In view of this, if the materials of the first gate conductive layer and the second gate conductive layer are the same, metal contact effect of conductive layers of the gates of the first field effect transistor and the second field effect transistor may be eliminated, that is, metal gate contact effect is eliminated.

Because the doping type of the first doped structure is opposite to the doping type of the second doped structure, the channel type of the first field effect transistor is opposite to the channel type of the second field effect transistor. In other words, if the doping type of the first doped structure is an N-type, and the doping type of the second doped structure is a P-type, the channel type of the first field effect transistor is an N-type, and the channel type of the second field effect transistor is a P-type. In other words, if the doping type of the first doped structure is a P-type, and the doping type of the second doped structure is an N-type, the channel type of the first field effect transistor is a P-type, and the channel type of the second field effect transistor is an N-type.

Refer to FIG. 15. In a possible implementation, to facilitate applying a voltage to the first gate conductive layer and the second gate conductive layer, an electrode structure 229 may further be formed on the first gate conductive layer and the second gate conductive layer after the first gate conductive layer and the second gate conductive layer are formed. The electrode structure 229 is further configured to fill a gap between adjacent first gate conductive layers and a gap between adjacent second gate conductive layers. A material of the electrode structure 229 includes, but is not limited to, a metal material such as aluminum or silver.

Refer to FIG. 15. To isolate electrode structures of adjacent semiconductor devices, an isolation layer 230 may also be formed on the electrode structures 229 through deposition. A material of the isolation layer 230 may be an insulation material, for example, oxide or silicon nitride. This is not specifically limited in this embodiment of this application.

It should be noted that, in another possible implementation, the first dielectric layer and the fifth dielectric layer may alternatively be replaced with air.

The following describes a structure of a forksheet semiconductor device manufactured by using the first process.

As shown in FIG. 15, the semiconductor device includes:
the substrate 201; the sidewall 208 disposed perpendicularly to the substrate 201; the plurality of first channel layers 224 sequentially disposed on one side of the sidewall 208 at an interval along a direction perpendicular to the substrate 201, and the plurality of second channel layers 225 sequentially disposed on another side of the sidewall 208 at an interval along a direction perpendicular to the substrate 201, where the first channel layer 224 extends along the side of the sidewall 208, and the second channel layer 225 extends along the side of the sidewall 208; a first doped structure 220 disposed at two ends of the plurality of first channel layers 224, and a second doped structure (not shown in FIG. 15) disposed at two ends of the plurality of second channel layers 225, where the doping type of the first doped structure 220 is opposite to the doping type of the second doped structure; the first dielectric layer (not shown in FIG. 15) covering one end of the first surface of the plurality of first channel layers 224 and one end of the first surface of the plurality of second channel layers 225, and the second dielectric layer 215 covering the other end of the first surface of the plurality of first channel layers 224 and the other end of the first surface of the plurality of second channel layers 225, where the first surface of the plurality of first channel layers 224 is a surface, of the plurality of first channel layers 224, that is away from the sidewall 208, and the first surface of the plurality of second channel layers 225 is a surface, of the plurality of second channel layers 225, that is away from the sidewall 208; the third dielectric layer (not shown in FIG. 15) disposed at two ends of the second surface of the plurality of first channel layers 224, and the fourth dielectric layer (not shown in FIG. 15) disposed at two ends of the second surface of the plurality of second channel layers 225, where the second surface of the plurality of first channel layers 224 is a surface, of the plurality of first channel layers 224, that is adjacent to the first surface of the plurality of first channel layers 224 and that is parallel with the substrate 201, and the second surface of the plurality of second channel layers 224 is a surface, of the plurality of second channel layers 224, that is adjacent to the first surface of the plurality of second channel layers 225 and that is parallel with the substrate 201; and the first gate insulation layer and the first gate conductive layer that are sequentially disposed on the first channel layer 224, and the second gate insulation layer and the second gate conductive layer that are sequentially disposed on the second channel layer 225.

It should be noted that in FIG. 15, the first gate insulation layer and the first gate conductive layer are not separately shown. In other words, in FIG. 15, 227 indicates a combination of the first gate insulation layer and the first gate conductive layer. Similarly, the second gate insulation layer and the second gate conductive layer are not separately shown. In other words, in FIG. 15, 228 indicates a combination of the second gate insulation layer and the second gate conductive layer.

The material of each part and location relationships between the parts are described above, and details are not described herein again.

It can be learned from the foregoing that the semiconductor device includes two field effect transistors: the first field effect transistor and the second field effect transistor. The first field effect transistor and the second field effect transistor are separately located at two sides of the sidewall. The plurality of first channel layers are a channel region of the first field effect transistor, the first doped structure is a source drain region of the first field effect transistor, the first gate insulation layer and the first gate conductive layer are a gate region of the first field effect transistor, and the first dielectric layer, the second dielectric layer, and the third dielectric layer isolate the gate region from the source drain region of the first field effect transistor. The plurality of second channel layers are a channel region of the second field effect transistor, the second doped structure is a source drain region of the second field effect transistor, the second gate insulation layer and the second gate conductive layer are a gate region of the second field effect transistor, and the first dielectric layer, the second dielectric layer, and the fourth dielectric layer isolate the gate region from the source drain region of the second field effect transistor.

The doping type of the first doped structure 220 is opposite to the doping type of the second doped structure, that is, the channel type of the first field effect transistor is opposite to the channel type of the second field effect transistor. In other words, if the doping type of the first doped structure 220 is an N-type (that is, the channel type of the first field effect transistor is an N-type), the doping type of the second doped structure is a P-type (that is, the channel type of the second field effect transistor is a P-type). If the doping type of the first doped structure 220 is a P-type (that is, the channel type of the first field effect transistor is a P-type), the doping type of the second doped structure is an N-type (that is, the channel type of the second field effect transistor is an N-type).

As shown in FIG. 15, the material of the first channel layer 224 is different from the material of the second channel layer 225, the first channel layer 224 and the second channel layer 225 are not in a same plane, and an upper surface of the first channel layer 224 is on a same plane with a lower surface of the second channel layer 225.

When the material of the first channel layer 224 is different from the material of the second channel layer 225, appropriate materials may be separately selected for the first channel layer and the second channel layer based on a type of the field effect transistor corresponding to the first channel layer and a type of the field effect transistor corresponding to the second channel layer, to improve performance of the field effect transistor, and further improve driving performance of the semiconductor device.

For example, in a feasible implementation, if the doping type of the first doped structure is a P-type, that is, the channel type of the first field effect transistor is a P-type, the doping type of the second doped structure is an N-type, that is, the channel type of the second field effect transistor is an N-type. A channel layer made of silicon germanium helps improve performance of the P-type field effect transistor, and a channel layer made of silicon helps improve performance of the N-type field effect transistor. Therefore, to improve performance of the first field effect transistor and the second field effect transistor, the material of the first channel layer is silicon germanium, and the material of the second channel layer is silicon.

It should be noted that in another possible implementation, the materials of the first channel layer 224 and the second channel layer 225 may be the same.

The materials of the first gate insulation layer and the second gate insulation layer may be the same or different. This is not specially limited in this embodiment of this application. The materials of the first gate conductive layer and the second gate conductive layer may be the same or different. This is not specially limited in this embodiment of this application.

Because the channel type of the first field effect transistor is opposite to the channel type of the second field effect transistor, the first field effect transistor and the second field effect transistor have different VTs (threshold voltage). The VT of the field effect transistor may be understood as a difference between a work function of a gate conductive layer and a Fermi level of a channel layer. In other words, if the VT (namely, a difference between a work function of the first gate conductive layer and a Fermi level of the first channel layer) of the first field effect transistor is a first value, and the VT (namely, a difference between a work function of the second gate conductive layer and a Fermi level of the second channel layer) of the second field effect transistor is a second value, and the first value is different from the second value. The first value is related to the channel type of the first field effect transistor, a structure of the first field effect transistor, and a parameter of each portion of the first field effect transistor. Similarly, the second value is related to the channel type of the second field effect transistor, a structure of the second field effect transistor, and a parameter of each portion of the second field effect transistor.

It should be noted that if the channel type of the field effect transistor is an N-type, the difference between the work function of the gate conductive layer and the Fermi level of the channel layer is greater than 0. If the channel type of the field effect transistor is a P-type, the difference between the work function of the gate conductive layer and the Fermi level of the channel layer is less than 0.

The VT (for example, the difference between the work function of the gate conductive layer and the Fermi level of the channel layer) of the field effect transistor may meet a requirement in at least one of the following four manners. The four manners are as follows:

The first manner is changing the Fermi level of the channel layer by adjusting a doping concentration and a doping type of the channel layer.

The second manner is that if the material of the channel layer is a semiconductor compound, the Fermi level of the channel layer is changed by adjusting a proportion of components in the semiconductor compound.

The third manner is that if a material of the gate insulation layer is a high-k material, the work function of the gate conductive layer is affected by selecting an appropriate high-k material of the gate insulation layer and/or changing a manufacturing process (for example, an annealing condition) of the gate insulation layer.

The fourth manner is that because different metal materials have different work functions, the gate conductive layer is made by selecting a metal material corresponding to a work function, to obtain a gate conductive layer that meets a work function requirement. In addition, if the material of the gate conductive layer is heavily doped polycrystalline silicon, the work function of the gate conductive layer is changed by changing a doping type and a doping concentration of polycrystalline silicon.

It can be learned from the foregoing that the VT of the field effect transistor may meet a requirement by adjusting the work function of the gate conductive layer and/or the Fermi level of the channel layer in at least one of the four manners.

Based on the foregoing principle, when the materials of the first gate insulation layer and the second gate insulation layer are the same, and the materials of the first gate conductive layer and the second gate conductive layer are the same (that is, when the work function of the first gate conductive layer and the work function of the second gate conductive layer are the same and determined), the Fermi level of the first channel layer and the Fermi level of the second channel layer are adjusted in at least one of the following two manners, so that the difference between the work function of the first gate conductive layer and the Fermi level of the first channel layer is the first value, and the difference between the work function of the second gate conductive layer and the Fermi level of the second channel layer is the second value, that is, the VT of the first field effect transistor and the VT of the second field effect transistor meet the requirement. The two manners are as follows:

The first manner is that if the material of the first channel layer and/or the material of the second channel layer are/is a semiconductor compound, a proportion of components in the semiconductor compound is adjusted.

The second manner is adjusting doping types and doping concentrations of the first channel layer and the second channel layer.

It is clear that when the materials of the first gate insulation layer and the second gate insulation layer are the same, and the materials of the first gate conductive layer and the second gate conductive layer are the same, that is, when the first field effect transistor and the second field effect transistor share the gate insulation layer and the gate conductive layer, the Fermi level of the first channel layer and the Fermi level of the second channel layer are adjusted in the foregoing manners, so that the VT of the first field effect transistor and the VT of the second field effect transistor meet the requirement. In addition, because the first field effect transistor and the second field effect transistor share the gate conductive layer and the gate insulation layer, metal contact effect, namely, metal gate contact effect, of the gates of the first field effect transistor and the second field effect transistor is eliminated. This improves performance of the device, and simplifies the manufacturing process of the semiconductor device. In addition, the Fermi level of the first channel layer and the Fermi level of the second channel layer are adjusted in the foregoing manners, so that the VT of the first field effect transistor and the VT of the second field effect transistor meet the requirement based on an energy band difference. Further, the first field effect transistor and the second field effect transistor can share the gate insulation layer and the gate conductive layer.

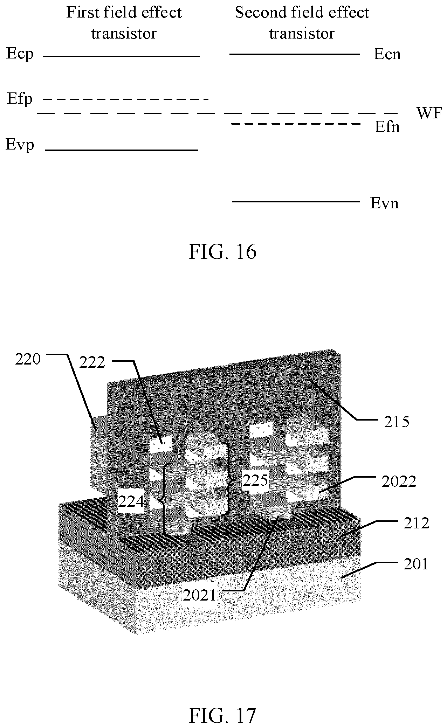

For example, FIG. 16 is a diagram of an energy band of the first field effect transistor and the second field effect transistor. As shown in FIG. 16, the first field effect transistor is a P-channel field effect transistor, and the second field effect transistor is an N-channel field effect transistor. The material of the first channel layer is silicon germanium, and the material of the second channel layer is silicon. The materials of the first gate conductive layer and the second gate conductive layer are the same, and the materials of the first gate insulation layer and the second gate insulation layer are the same.

In view of this, the materials of the first gate conductive layer and the second gate conductive layer may be first determined based on the Fermi level (a Fermi level of silicon) of the second channel layer, so that the work function WF of the first gate conductive layer and the work function WF of the second gate conductive layer are greater than the Fermi level Efn of the second channel layer, and the VT of the second field effect transistor is the second value. Then, the Fermi level Efp of the first channel layer is changed by adjusting a silicon germanium component, so that the Fermi level Efp of the first channel layer is greater than the work function WF of the first gate conductive layer and the work function WF of the second gate conductive layer, and the VT of the first field effect transistor is the first value. In FIG. 16, Ecp is a conduction band of the first channel layer, Evp is a valence band of the first channel layer, Ecn is a conduction band of the second channel layer, and Evn is a valence band of the second channel layer.

Based on the foregoing principle, when the materials of the first gate conductive layer and the second gate conductive layer are the same, at least one of the following three manners may be used, so that the difference between the work function of the first gate conductive layer and the Fermi level of the first channel layer is the first value, and the difference between the work function of the second gate conductive layer and the Fermi level of the second channel layer is the second value. The three manners are as follows:

The first manner is that when the materials of the first gate insulation layer and the second gate insulation layer are high-k materials, types of the high-k materials corresponding to the first gate insulation layer and the second gate insulation layer and/or manufacturing processes (for example, annealing temperature and time) of the first gate insulation layer and the second gate insulation layer are adjusted.

The second manner is that if the material of the first channel layer and/or the material of the second channel layer are/is a semiconductor compound, a proportion of components in the semiconductor compound is adjusted.

The third manner is adjusting doping types and doping concentrations of the first channel layer and the second channel layer.

It is clear that when the first field effect transistor and the second field effect transistor share the gate conductive layer (that is, the materials of the first gate conductive layer and the second gate conductive layer are the same), the Fermi level of the first channel layer and the Fermi level of the second channel layer and/or the work function of the first gate conductive layer and the work function of the second gate conductive layer are adjusted in the foregoing manners, so that the VT of the first field effect transistor and the VT of the second field effect transistor meet the requirement. In addition, because the first field effect transistor and the second field effect transistor share the gate conductive layer, metal contact effect of the gates of the first field effect transistor and the second field effect transistor is eliminated. This improves performance of the device, and simplifies the manufacturing process of the semiconductor device. In addition, the Fermi level of the first channel layer and the Fermi level of the second channel layer and/or the work function of the first gate conductive layer and the work function of the second gate conductive layer are adjusted in the foregoing manners, so that the VT of the first field effect transistor and the VT of the second field effect transistor meet the requirement based on an energy band difference. Therefore, the first field effect transistor and the second field effect transistor can share the gate conductive layer.

It should be noted that the foregoing manners are merely examples, and are not intended to limit this application.

When the materials of the first gate insulation layer and the second gate insulation layer are the same, at least one of the following three manners may be used, so that the difference between the work function of the first gate conductive layer and the Fermi level of the first channel layer is the first value, and the difference between the work function of the second gate conductive layer and the Fermi level of the second channel layer is the second value. The three manners are as follows:

The first manner is adjusting doping types and doping concentrations of the first channel layer and the second channel layer.

The second manner is that if the material of the first channel layer and/or the material of the second channel layer are/is a semiconductor compound, a proportion of components in the semiconductor compound is adjusted.

The third manner is selecting appropriate metal materials of the first gate conductive layer and the second gate conductive layer, or adjusting doping types and doping concentrations of the first gate conductive layer and the second gate conductive layer (if the first gate conductive layer and the second gate conductive layer are heavily doped polycrystalline silicon).

It is clear that in the foregoing manners, when the first field effect transistor and the second field effect transistor share the gate insulation layer, the Fermi level of the first channel layer and the Fermi level of the second channel layer and/or the work function of the first gate conductive layer and the work function of the second gate conductive layer are adjusted in the foregoing manners, so that the VT of the first field effect transistor and the VT of the second field effect transistor meet the requirement. In addition, because the first field effect transistor and the second field effect transistor share the gate insulation layer, the manufacturing process of the semiconductor device is simplified.

It should be noted that the foregoing manners are merely examples, and are not intended to limit this application.

Refer to FIG. 15. To avoid forming a parasitic device caused by connecting the substrate to the first field effect transistor and the second field effect transistor, and avoid affecting performance of the first field effect transistor and the second field effect transistor, the semiconductor device further includes the fifth dielectric layer 212. The fifth dielectric layer 212 is located between the substrate 201 and the field effect transistor, that is, the fifth dielectric layer 212 is located on the substrate 201, and the plurality of first channel layers 224, the plurality of second channel layers 225, the first doped structure 220, and the second doped structure are located on the fifth dielectric layer 212.

As shown in FIG. 15, to facilitate applying a voltage to the first gate conductive layer and the second gate conductive layer, the semiconductor device further includes the electrode structure 229. The electrode structure 229 is located on the first gate conductive layer and the second gate conductive layer, and is configured to connect the first gate conductive layer to the second gate conductive layer.

As shown in FIG. 15, to isolate electrode structures of adjacent semiconductor devices, the semiconductor device further includes the isolation layer 230 that covers the electrode structure 229. It should be noted that a hole is disposed on the isolation layer 230, to extrude the electrode structure 229 from the hole.

It should be noted that because each part is described in the foregoing, details are not described herein again. In addition, FIG. 15 is merely one structure of the semiconductor device manufactured by using the first process, and is not intended to limit this application.

A procedure of the second process is as follows:
Because the first process is the same as the second process in forming the plurality of first channel layers and the plurality of second channel layers, the following describes only a procedure after the plurality of first channel layers and the plurality of second channel layers are formed in the second process. The specific procedure of the second process is as follows:
The sidewall between the first dielectric layer and the second dielectric layer is removed through etching. In a possible implementation, a structure obtained after the sidewall between the first dielectric layer and the second dielectric layer is removed is shown in FIG. 17.

The gate insulation layer is formed on the first channel layer and the second channel layer through deposition. Specifically, the gate insulation layer is deposited on the exposed surface of the first channel layer and the exposed surface of the second channel layer. The first channel layer and the second channel layer are described above, and details are not described herein again. The materials of the insulation layer may be, for example, silicon dioxide or a high-k material (for example, ZrO₂, HfO₂, or Al₂O₃). This is not specially limited herein.

The gate conductive layer is formed on the gate insulation layer through deposition. The material of the gate conductive layer may be, for example, a metal material and heavily doped polycrystalline silicon. This is not specifically limited herein.

It can be learned from the foregoing that because the sidewall between the first dielectric layer and the second dielectric layer is removed, four sides of the first channel layer and the second channel layer are exposed to the outside. Therefore, a gate-all-around structure may be formed. In other words, a gate region formed by the gate insulation layer and the gate conductive layer covers the four sides of the first channel layer and the second channel layer, to improve a gate driving capability of the device.

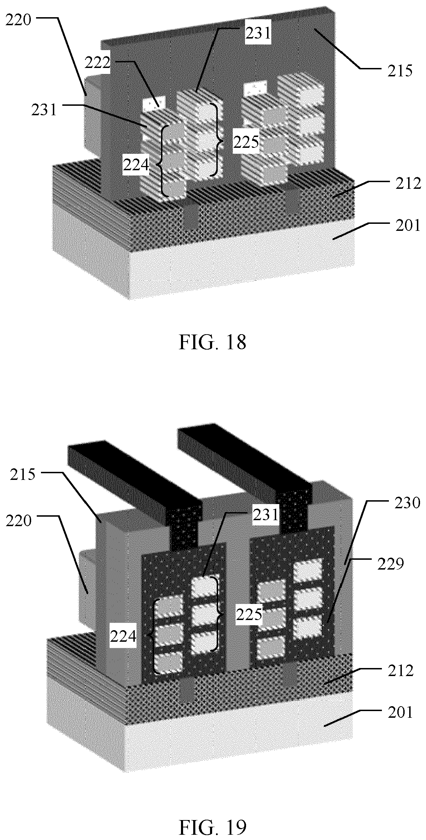

In a possible implementation, FIG. 18 shows the semiconductor device in which the gate insulation layer and the gate conductive layer are sequentially formed on the first channel layer and the second channel layer. Refer to FIG. 18. The gate insulation layer and the gate conductive layer form a gate-all-around structure on the first channel layer 224 and the second channel layer 225. It should be noted that in FIG. 18, the gate insulation layer and the gate conductive layer are not separately shown. In other words, in FIG. 18, 231 indicates a combination of the gate insulation layer and the gate conductive layer.

It can be learned from the foregoing that the semiconductor device includes two field effect transistors: the first field effect transistor and the second field effect transistor. The plurality of first channel layers are a channel region of the first field effect transistor, the first doped structure is a source drain region of the first field effect transistor, the gate insulation layer and the gate conductive layer are a gate region of the first field effect transistor, and the first dielectric layer, the second dielectric layer, and the third dielectric layer isolate the gate region from the source drain region of the first field effect transistor. The plurality of second channel layers are a channel region of the second field effect transistor, the second doped structure is a source drain region of the second field effect transistor, the gate insulation layer and the gate conductive layer are further a gate region of the second field effect transistor, and the first dielectric layer, the second dielectric layer, and the fourth dielectric layer isolate the gate region from the source drain region of the second field effect transistor.

Because the first channel layer and the second channel layer share the gate insulation layer and the gate conductive layer, the process is simplified, and metal contact effect of the gates of the first field effect transistor and the second field effect transistor can be eliminated. In addition, because the sidewall is removed, an exposed area of the first channel layer and the second channel layer is increased, and a coverage area of the gate insulation layer and the gate conductive layer is further increased. This further increases a gate control capability of the device.

Refer to FIG. 19. In the second process, in a feasible implementation, the fifth dielectric layer 212, the electrode structure 229, and the isolation layer 230 may also be formed. The purpose and principle of forming the fifth dielectric layer 212, the electrode structure 229, and the isolation layer 230 are the same as the purpose and principle in the first process. Details are not described herein again.

The following describes a structure of a forksheet semiconductor device manufactured by using the second process.

As shown in FIG. 19, a difference between the semiconductor device and the semiconductor device manufactured by using the first manufacturing process is as follows:
The sidewall 208 between the first dielectric layer and the second dielectric layer 215 is removed. The first gate insulation layer and the first gate conductive layer are sequentially disposed on a surface that is in contact with the removed sidewall 208 and that is in the first channel layer 224. The second gate insulation layer and the second gate conductive layer are sequentially disposed on a surface that is in contact with the removed sidewall 208 and that is in the second channel layer 225. The materials of the first gate insulation layer and the second gate insulation layer are the same, and the materials of the first gate conductive layer and the second gate conductive layer are the same.

It should be noted that because the materials of the first gate insulation layer and the second gate insulation layer are the same, the first gate insulation layer and the second gate insulation layer are collectively referred to as a gate insulation layer. Because the materials of the first gate conductive layer and the second gate conductive layer are the same, the first gate conductive layer and the second gate conductive layer are collectively referred to as a gate conductive layer. In view of this, in FIG. 19, the gate insulation layer and the gate conductive layer are not separately shown. In other words, in FIG. 19, 231 indicates a combination of the gate insulation layer and the gate conductive layer.

It can be learned from the foregoing that the sidewall is removed, so that the four sides of the first channel layer and the second channel layer are exposed to the outside. Therefore, a gate-all-around structure (the gate-all-around structure includes the first gate insulation layer and the first gate conductive layer) can be formed on the first channel layer, and a gate-all-around structure (the gate-all-around structure includes the second gate insulation layer and the second gate conductive layer) can be formed on the second channel layer. This increases a gate drive capability of the device. In addition, because the materials of the first gate insulation layer and the second gate insulation layer are the same, and the materials of the first gate conductive layer and the second gate conductive layer are the same, the first field effect transistor and the second field effect transistor form a common-gate structure. This simplifies the manufacturing process, and reduces manufacturing costs.

Because the channel type of the first field effect transistor is opposite to the channel type of the second field effect transistor, the first field effect transistor and the second field effect transistor have different VTs (threshold voltage). The VT of the field effect transistor may be understood as a difference between a work function of a gate conductive layer and a Fermi level of a channel layer. In other words, the VT (the difference between the work function of the gate conductive layer and the Fermi level of the first channel layer) of the first field effect transistor is the first value, the VT (the difference between the work function of the gate conductive layer and the Fermi level of the second channel layer) of the second field effect transistor is the second value, and the first value is different from the second value.

Because in the forksheet semiconductor device manufactured by using the second process, the first field effect transistor and the second field effect transistor share the gate insulation layer and the gate conductive layer, at least one of the following two manners may be used, so that the difference between the work function of the gate conductive layer (namely, the first gate conductive layer) and the Fermi level of the first channel layer is the first value, and the difference between the work function of the gate conductive layer (namely, the second gate conductive layer) and the Fermi level of the second channel layer is the second value. The two manners are as follows:
The first manner is that if the material of the first channel layer and/or the material of the second channel layer are/is a semiconductor compound, a proportion of components in the semiconductor compound is adjusted.

The second manner is adjusting doping types and doping concentrations of the first channel layer and the second channel layer.

It is clear that when the first field effect transistor and the second field effect transistor share the gate insulation layer and the gate conductive layer, the Fermi level of the first channel layer and the Fermi level of the second channel layer are adjusted in the foregoing manners, so that the VT of the first field effect transistor and the VT of the second field effect transistor meet the requirement. In addition, because the first field effect transistor and the second field effect transistor share the gate conductive layer and the gate insulation layer, metal contact effect of the gates of the first field effect transistor and the second field effect transistor is eliminated. This improves performance of the device, and simplifies the manufacturing process of the semiconductor device. In addition, the Fermi level of the first channel layer and the Fermi level of the second channel layer are adjusted in the foregoing manners, so that the VT of the first field effect transistor and the VT of the second field effect transistor meet the requirement based on an energy band difference. Further, the first field effect transistor and the second field effect transistor can share the gate insulation layer and the gate conductive layer.

To avoid forming a parasitic device caused by connecting the substrate to the first field effect transistor and the second field effect transistor, and avoid affecting performance of the first field effect transistor and the second field effect transistor, as shown in FIG. 19, the semiconductor device further includes the fifth dielectric layer 212. The fifth dielectric layer 212 is located between the substrate 201 and the field effect transistor, that is, the fifth dielectric layer 212 is located on the substrate 201, and the plurality of first channel layers 224, the plurality of second channel layers 225, the first doped structure 220, and the second doped structure are located on the fifth dielectric layer 212.

As shown in FIG. 19, to facilitate applying a voltage to the gate conductive layer (namely, the first gate conductive layer and the second gate conductive layer), the semiconductor device further includes the electrode structure 229, and the electrode structure 229 is located on the gate conductive layer. To isolate electrode structures 229 of different semiconductor devices, the semiconductor device further includes the isolation layer 230 that covers the electrode structure 229. It should be noted that a hole is disposed on the isolation layer 230, to extrude the electrode structure 229 from the hole.

It should be noted that the drawings related to the structure and the process provided above are all drawn on the basis of forming two forksheet semiconductor devices that are the same.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for forming a sidewall in a forksheet structure, comprising:
providing a substrate;
forming, on the substrate, an overlapping layer in which first materials and second materials are sequentially stacked;
forming a first mask layer on the overlapping layer;
forming a first trench in the first mask layer;
forming a second trench in the first trench by forming a second mask layer in the first mask layer and the first trench;
etching, through anisotropic etching, the second mask layer along a direction perpendicular to the substrate, until the second mask layer that is located between sides of the second trench and on a lower surface of the first trench is removed, to form a third trench based on the second trench;
etching downwards from a lower surface of the third trench by using the second mask layer as a protective layer, to form a fourth trench that penetrates the overlapping layer and extends to the substrate; and
forming a sidewall in the fourth trench.

2. The method according to claim 1, wherein the method further comprises:
forming a first overlapping structure and a second overlapping structure on two sides of the sidewall, wherein the first overlapping structure, the second overlapping structure, and the sidewall are covered with a first dielectric layer and a second dielectric layer, one end of the first dielectric layer is on a same plane with one end of the first overlapping structure and one end of the second overlapping structure, one end of the second dielectric layer is on a same plane with the other end of the first overlapping structure and the other end of the second overlapping structure, and the other end of the first dielectric layer is at a preset distance from the other end of the second dielectric layer;
removing a first target material covered by the first dielectric layer and the second dielectric layer in the first overlapping structure, and removing a second target material covered by the first dielectric layer and the second dielectric layer in the second overlapping structure;
forming a third dielectric layer in a region from which the first target material is removed, to obtain a third overlapping structure;
forming a fourth dielectric layer in a region from which the second target material is removed, to obtain a fourth overlapping structure;
forming a first doped structure at two ends of the third overlapping structure, and forming a second doped structure at two ends of the fourth overlapping structure;
removing the first target material in the third overlapping structure, to form a plurality of first channel layers; and
removing the second target material in the fourth overlapping structure, to form a plurality of second channel layers, wherein
the first target material is a material that is in the first material and the second material and that is not used to form the first channel layer, the second target material is a material that is in the first material and the second material and that is not used to form the second channel layer, and a doping type of the first doped structure is opposite to a doping type of the second doped structure.

3. The method according to claim 2, wherein the method further comprises:
forming a first gate insulation layer on the first channel layer, and forming a second gate insulation layer on the second channel layer; and
forming a first gate conductive layer on the first gate insulation layer, and forming a second gate conductive layer on the second gate insulation layer.

4. The method according to claim 3, wherein materials of the first gate insulation layer and the second gate insulation layer are the same, and materials of the first gate conductive layer and the second gate conductive layer are the same; or
materials of the first gate conductive layer and the second gate conductive layer are the same.

5. The method according to claim 2, wherein the method further comprises:
removing the sidewall between the first dielectric layer and the second dielectric layer;
forming a gate insulation layer on the first channel layer and the second channel layer; and
forming a gate conductive layer on the gate insulation layer.

6. The method according to any one of claims 2 to 5, wherein the forming a first overlapping structure and a second overlapping structure on two sides of the sidewall comprises:
forming a fifth overlapping structure and a sixth overlapping structure that are located on two sides of the sidewall by removing a to-be-removed mask layer and an overlapping layer that is located under the to-be-removed mask layer, wherein the to-be-removed mask layer is the first mask layer located outside sides of the first trench;
forming a dummy gate structure covering the fifth overlapping structure, the sixth overlapping structure, and the sidewall, wherein a length of the dummy gate structure is equal to the preset distance;
forming the first dielectric layer and the second dielectric layer at two ends of the dummy gate structure;
removing a region that is not covered by the dummy gate structure, the first dielectric layer, and the second dielectric layer in the fifth overlapping structure, to obtain the first overlapping structure; and
removing a region that is not covered by the dummy gate structure, the first dielectric layer, and the second dielectric layer in the sixth overlapping structure, to obtain the second overlapping structure.

7. The method according to claim 6, wherein before forming the plurality of first channel layers and the plurality of second channel layers, the method further comprises:
removing the dummy gate structure.

8. The method according to any one of claims 2 to 7, wherein the method further comprises:
forming a fifth dielectric layer on the substrate, wherein the plurality of first channel layers, the plurality of second channel layers, the first doped structure, and the second doped structure are located on the fifth dielectric layer.

9. The method according to any one of claims 2 to 8, wherein materials of the first channel layer and the second channel layer are different.

10. The method according to any one of claims 2 to 9, wherein the first doped structure is P-type doping, the second doped structure is N-type doping, the material of the first channel layer is silicon-germanium, and the material of the second channel layer is silicon.

11. A forksheet semiconductor device, comprising:
a substrate;
a sidewall disposed perpendicularly to the substrate;
a plurality of first channel layers sequentially spaced apart on one side of the sidewall along a direction perpendicular to the substrate, wherein the first channel layer extends along the side of the sidewall;
a plurality of second channel layers sequentially spaced apart on another side of the sidewall along a direction perpendicular to the substrate, wherein the second channel layer extends along the side of the sidewall;
a first doped structure disposed at two ends of the plurality of first channel layers, and a second doped structure disposed at two ends of the plurality of second channel layers, wherein a doping type of the first doped structure is opposite to a doping type of the second doped structure;
a first dielectric layer covering one end of a first surface of the plurality of first channel layers and one end of a first surface of the plurality of second channel layers, and a second dielectric layer covering the other end of the first surface of the plurality of first channel layers and the other end of the first surface of the plurality of second channel layers, wherein the first surface of the plurality of first channel layers is a surface, of the plurality of first channel layers, that is away from the sidewall, and the first surface of the plurality of second channel layers is a surface, of the plurality of second channel layers, that is away from the sidewall;
a third dielectric layer disposed at two ends of a second surface of the plurality of first channel layers, and a fourth dielectric layer disposed at two ends of a second surface of the plurality of second channel layers, wherein the second surface of the plurality of first channel layers is a surface, of the plurality of first channel layers, that is adjacent to the first surface of the plurality of first channel layers and that is parallel with the substrate, and the second surface of the plurality of second channel layers is a surface, of the plurality of second channel layers, that is adjacent to the first surface of the plurality of second channel layers and that is parallel with the substrate; and
a first gate insulation layer and a first gate conductive layer that are sequentially disposed on the first channel layer, and a second gate insulation layer and a second gate conductive layer that are sequentially disposed on the second channel layer.

12. The semiconductor device according to claim 11, wherein the semiconductor device further comprises:
a fifth dielectric layer on the substrate, wherein the plurality of first channel layers, the plurality of second channel layers, the first doped structure, and the second doped structure are located on the fifth dielectric layer.

13. The semiconductor device according to claim 11 or 12, wherein materials of the first gate insulation layer and the second gate insulation layer are the same, and materials of the first gate conductive layer and the second gate conductive layer are the same; or
materials of the first gate conductive layer and the second gate conductive layer are the same.

14. The semiconductor device according to claim 11 or 12, wherein the sidewall between the first dielectric layer and the second dielectric layer is removed;
the first gate insulation layer and the first gate conductive layer are sequentially disposed on a surface that is in contact with the removed sidewall and that is in the first channel layer;
the second gate insulation layer and the second gate conductive layer are sequentially disposed on a surface that is in contact with the removed sidewall and that is in the second channel layer; and
materials of the first gate insulation layer and the second gate insulation layer are the same, and materials of the first gate conductive layer and the second gate conductive layer are the same.

15. The semiconductor device according to any one of claims 11 to 14, wherein materials of the first channel layer and the second channel layer are different.

16. The semiconductor device according to any one of claims 11 to 14, wherein the first doped structure is P-type doping, the second doped structure is N-type doping, the material of the first channel layer is silicon-germanium, and the material of the second channel layer is silicon.
